# EUROPEAN PATENT SPECIFICATION

(11) **EP 3 306 325 B1**
(45) Date of publication and mention of the grant of the patent: **21.07.2021**
(21) Application number: 16382457.6
(22) Date of filing: 05.10.2016
(51) Int. Cl.: G01R 15/20, G01D 3/024, G01R 33/00

(54) **A CURRENT MEASURING DEVICE**
STROMMESSVORRICHTUNG
DISPOSITIF DE MESURE DE COURANT

(43) Date of publication of application: 11.04.2018
(73) Proprietor: Fico Triad, S.A., 08028 Barcelona (ES)
(72) Inventor: PLANAS GIRONA, Albert, 08028 BARCELONA (ES)
(74) Representative: Herrero & Asociados, S.L.

(56) References cited:
- WO-A1-2012/137389
- JP-B2- 3 234 394
- US-A1- 2004 196 024
- US-A1- 2013 162 246
- US-B2- 9 250 273

## Description

### Object of the invention

The present invention relates to a new design of a current measuring device, specifically designed for being adapted to any conductor or bus bar geometry, such as the conductors of a Battery Junction Box (BJB) of a vehicle.

The object of this invention is to provide a contact-less device that offers a simple and flexible design capable of being installed on any planar conductor geometry.

Another object of this invention is to provide a current measuring device that can measure a wide range of magnetic fields with a high degree of accuracy.

### Background of the invention

The use of direct current measuring devices is extremely widespread in particular for electrical vehicle applications.

In the electrical vehicle field, the efficient running and automation of the electric power systems necessitates accurate and reliable digital control and protection systems for the high voltage elements. Current and voltage sensors for controlling and measuring the current and voltage of elements forming the Battery Junction Box are indispensable for this purpose.

Prior art systems for the control and measurement of current was effected by using a large, wound-type transformer, with a core and windings, to transform the magnetic field produced by the electric current into a current and voltage. However, the windings and core used in these transformers took up a lot of space, and generated problems related with poor insulation against high voltages and poor resistance to electromagnetic noises.

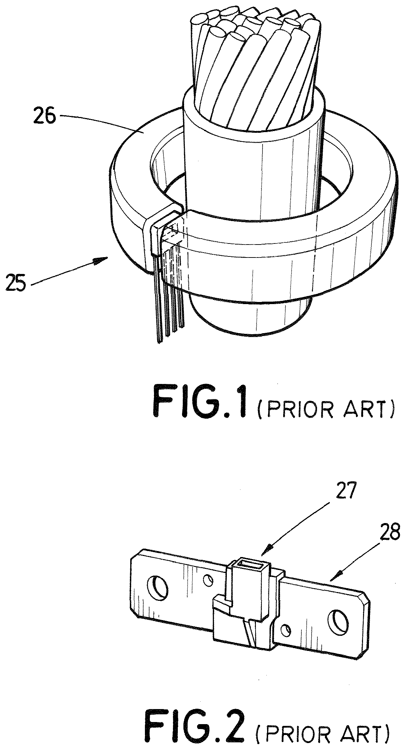

Other prior art systems for the measurement of current consists on an open loop current sensor combined with a ferromagnetic core. Figure 1 shows an example of this kind of prior art solution, consisting on a conventional Hall sensor 25. These current sensors 25 are easy to adapt to different bus bars 26 geometries, but their sensitive and performance (signal-to-noise ratio) in front of EMI (ElectroMagnetic Interference) are perfectible.

Figure 2 shows another prior art system for the measurement of current, a shunt sensor 27. A shunt sensor is a device that measure the voltage drop created at both ends of a controlled resistance when a specific current is passing through it. The voltage drop is proportional to the current value. However, the controlled resistance should be welded in the middle of the bus bar 28 and the voltage measuring point should be in contact with both ends of the resistance, which makes that this is not an easy to adapt solution.

US9250273 B2 discloses a current sensor including: a current bar through which a current flows; a first cover that covers the current bar and includes a cutout portion formed in at least a part thereof; a magnetic substance core that covers at least parts of the current bar and the first cover and includes a gap; a magnetic field measuring element located in the gap; and a second cover that covers the magnetic substance core and the magnetic field measuring element and at least parts of the current bar and the first cover, and is located so that a side surface thereof engages with the cutout portion of the first cover.

US2013162246A1 discloses in a current detecting apparatus, a container member includes a substrate fixing portion, a core inner-edge positioning portions, and a lid member. The substrate fixing portion is a portion formed at a position outside an outer edge of a magnetic core, and to which a first portion of a circuit board is fixed. Two of the core inner-edge positioning portions come into contact with the magnetic core, and come into contact with the circuit board. The first portion, the second portion, and the third portion surround a magnetoelectric device, such as a Hall element, that detects a magnetic flux in a gap portion of the magnetic core.

US2004196024A1 discloses an integrated current sensor includes a magnetic field transducer such as a Hall effect sensor, a magnetic core, and an electrical conductor. The conductor includes features for receiving portions of the Hall effect sensor and the core and the elements are dimensioned such that little or no relative movement among the elements is possible.

Then, it would be desirable to develop an improved current measuring device that is easy to adapt to any conductor geometry, at the same time that provides an accurate and reliable measurement.

### Description of the invention

The present invention overcomes the above mentioned drawbacks by providing a new current measuring device, which further than having a reduced size is easily adaptable to different conductors, allowing thus a flexible implementation.

The invention refers to a current measuring device for a conductor having first and second sides. The device is defined by the features of independent claim 1.

Thus, the invention provides a contact-less solution, easy to adapt to any conductor configuration. This way, the invention can be used at multiple applications of the power electronics field, providing a simple and cost-effective current measuring device.

Further, the invention offers a compact device that allows its usage at reduced and intricate spaces.

According to a preferred embodiment, the current measuring device further comprises a U-shaped flux concentrator having a central portion coupled to respective side portions, wherein the flux concentrator is received by the board, such that the first magnetic sensor is disposed between the side portions of said flux concentrator to converge a flux generated by a current flowing through the conductor towards said first magnetic sensor.

The flux concentrator concentrates the magnetic field created by a current flowing through the conductor, and avoids the interference of any other external magnetic fields. The invention provides this way a more reliable and accurate current measure.

According to the invention, the current measuring device further comprises at least a second magnetic sensor, wherein the first and second magnetic sensors are consecutively disposed on the board along to a same or a substantially parallel direction in which a current would flow through the conductor.

The current range of one of the magnetic sensors is within the current range of the other magnetic sensor.

Providing two sensors, the current measuring device allows dividing the total measurement range in two ranges, one short-range magnetic sensor and one long-range magnetic sensor. This way, the invention provides a more precise and complete measure, which can be customized to specific cases.

### Brief description of the drawings

For a better comprehension of the invention, the following drawings are provided for illustrative and non-limiting purposes, wherein:
Figure 1 shows a conventional Hall sensor for measuring the current flowing through a bus bar conductor.
Figure 2 shows a conventional shunt sensor for measuring a drop voltage value, which is proportional to the current flowing through the planar conductor.
Figure 3 shows a perspective view of a current measuring device not forming part of the invention of the invention, wherein drawings (A), (B) and (C) show the adaptation of the device to different conductor configurations.
Figure 4 shows a graphic (drawing A) and an enlarged detail (drawing B) of the error of the first and second magnetic sensors of a current measuring device vs the electric current passing through a conductor, according to a preferred embodiment of the invention.
Figure 5 shows a perspective view of a U-shaped flux concentrator, according to a preferred embodiment of the invention.
Figure 6 shows a perspective view of a current measuring device according to an example not forming part of the invention, wherein drawing (A) is an exploded view, and drawings (B) and (C) are different lateral views of the device coupled to the conductor.
Figure 7 shows a perspective view of a current measuring device according to an example not forming part of the invention, wherein drawing (A) is an exploded view, and drawings (B) and (C) are different lateral views of the device coupled to the conductor.
Figure 8 shows a perspective view of a current measuring device according to an example not forming part of the invention, wherein drawing (A) is an exploded view, and drawings (B) and (C) are different lateral views of the device coupled to the conductor.
Figure 9 shows a perspective view of a current measuring device according to an example not forming part of the invention, wherein drawing (A) is an exploded view, and drawings (B) and (C) are different lateral views of the device coupled to the conductor.
Figure 10 shows a perspective view of a current measuring device according to an embodiment of the invention, wherein drawing (A) is an exploded view, and drawings (B) and (C) are different lateral views of the device coupled to the conductor.
Figure 11 shows a perspective view of a current measuring device according to a further embodiment of the invention, wherein drawing (A) is an exploded view, and drawings (B) and (C) are different lateral views of the device coupled to the conductor.
Figure 12 shows a perspective view of a current measuring device according to a further embodiment of the invention, wherein drawing (A) is a lateral view of a partially formed device coupled to the conductor, and drawing (B) is the same lateral view shown in drawing (A) in which the device is completely formed.
Figure 13 shows a perspective view of a current measuring device according to a further embodiment of the invention, wherein drawing (A) is a lateral view of a partially formed device coupled to the conductor, and drawing (B) is the same lateral view shown in drawing (A) in which the device is completely formed.

### Preferred embodiments of the invention

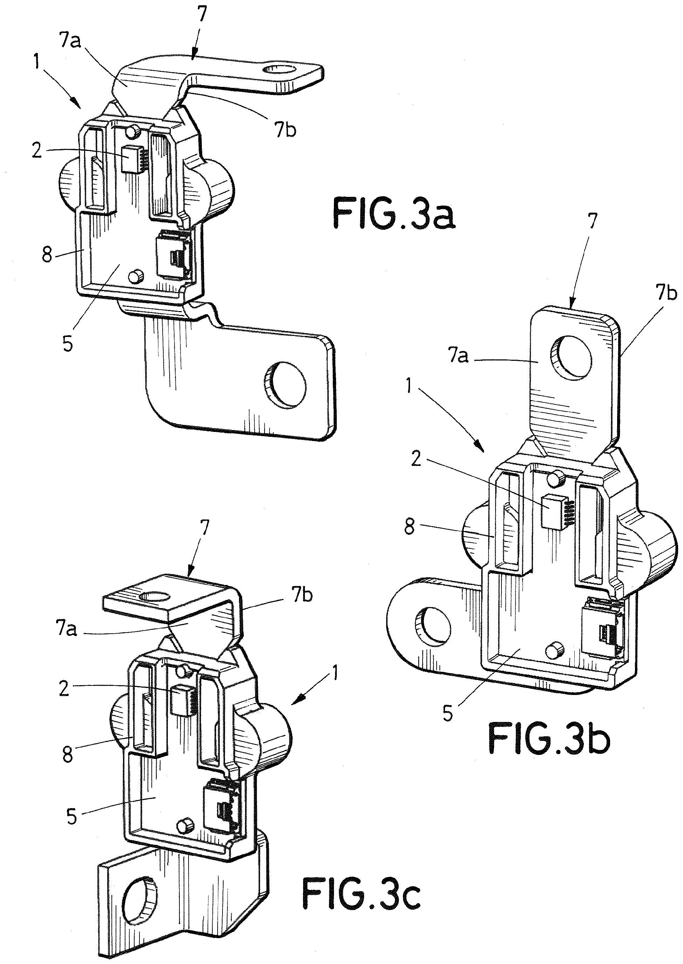

Figure 3 shows a current measuring device 1, according to an example not forming part of the invention. As shown, the device 1 comprises a first magnetic sensor 2, a printed-circuit board 5 on which the first magnetic sensor 2 is disposed, and a first non-conductive element 8. The first magnetic sensor 2 is adapted to sense, in a first current range, a magnetic field generated by a current flowing through the conductor 7, and is disposed along to a same or a substantially parallel direction in which a current would flow through the conductor 7.

As shown in Figures 3a, 3b and 3c, the current measuring device 1 can be adapted to different conductor geometries. Also, the first non-conductive element 8 can be coupled to either the first 7a or the second side 7b of the conductor 7.

Thus, the example provides a contact-less solution, easy to adapt to any conductor geometry.

According to the invention, the current measuring device 1 further comprises a second magnetic sensor 3, adapted to operate on a second current range, wherein the first and second magnetic sensors 2, 3 are consecutively disposed on the board 5 along to a same or a substantially parallel direction in which a current would flow through the conductor 7.

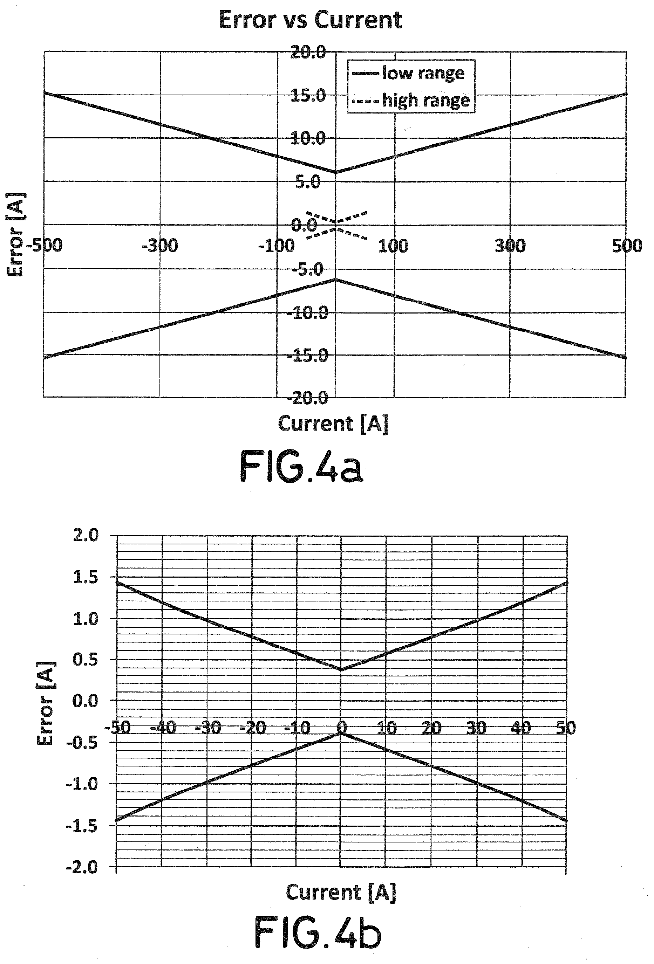

Figure 4 shows a graphic representing the relation between the error of the first and second magnetic sensors 2, 3 and the electric current passing through the conductor, in which one current range is contained into the other current range. Preferably, the first magnetic sensor 2 is a long-range magnetic sensor, operating at a bigger current range, and the second magnetic sensor 3 is a short-range magnetic sensor, operating at a lower current range. This way, the second magnetic sensor 3 improves the accuracy of the first magnetic sensor 2, and therefore, the accuracy of the device 1.

As shown, the first magnetic sensor 2 may be configured to operate having a sensing range of ±52mT at ±500A, and the second magnetic sensor 3 may be configured to operate having a sensing range of ±5mT at ±50A. For instance, in this way, in current values near to zero, the error would pass from 5A, measured by the first magnetic sensor 2, to 0.5A, measured by the second magnetic sensor 3.

Also, in a preferred embodiment, the first magnetic sensor 2 is configured to operate having a gain of at least 1,5 at 500A, and the second magnetic sensor 3 is configured to operate having a gain of at least 6 at 50A. Thus, the first magnetic sensor 2 is preferably adapted to operate at VHF (Very High Field), and the second magnetic sensor 3 is adapted to operate at LF (Low Field).

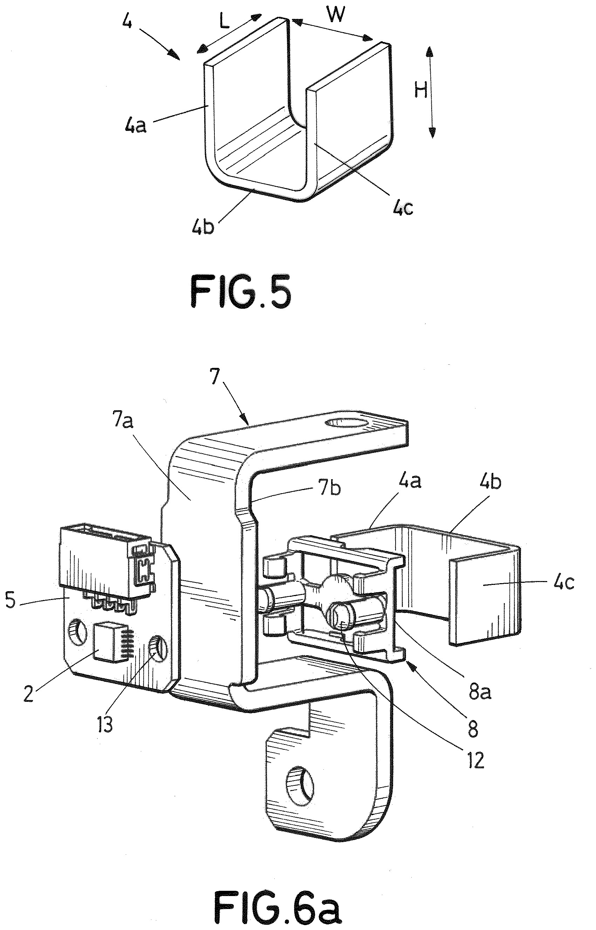

According to a preferred embodiment, the current measuring device 1 further comprises a U-shaped flux concentrator 4. As shown in Figure 5, the flux concentrator 4 has a central portion 4b coupled to respective side portions 4a, 4c.

The flux concentrator 4 has this configuration to be received by the board 5, in such a way that the at least one of the first and second magnetic sensors 2, 3 is disposed between the side portions 4a, 4c of the flux concentrator 4 to converge a flux generated by a current flowing through the conductor 7 towards the at least one of the first and second magnetic sensors 2, 3.

The flux concentrator 4 drives the magnetic fields towards at least one of the first and second magnetic sensors 2, 3, thus offering an accurate measure of the current flowing through the conductor 7.

Also, the flux concentrator 4 improves the device accuracy by measuring currents flowing through the conductor 7.

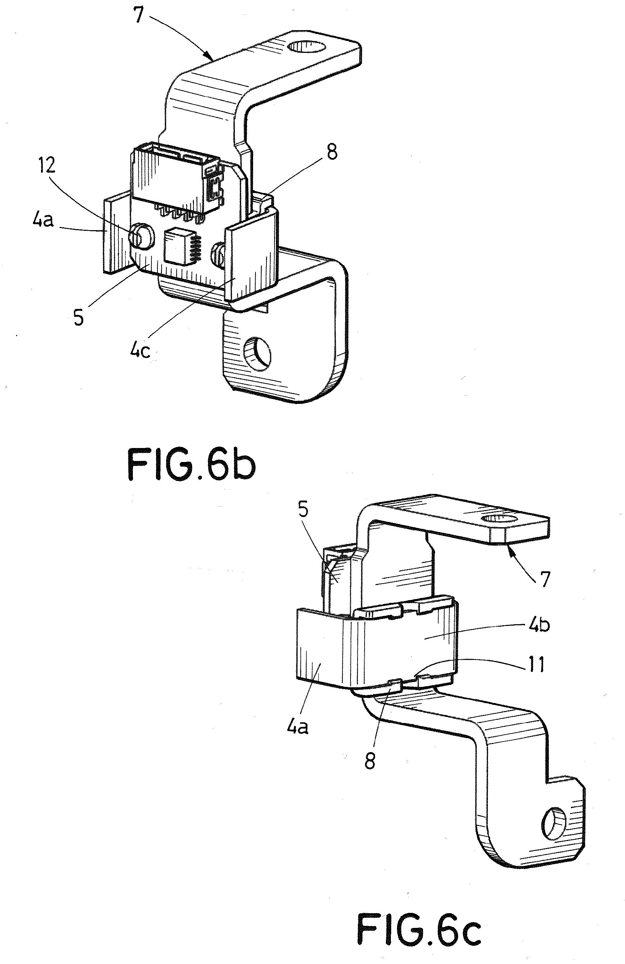

Figure 6 shows a current measuring device 1, according to an example not forming part of the invention, in which the device 1 comprises the first magnetic sensor 2, the printed-circuit board 5 on which the first magnetic sensor 2 is disposed, the first non-conductive element 8, and the flux concentrator 4.

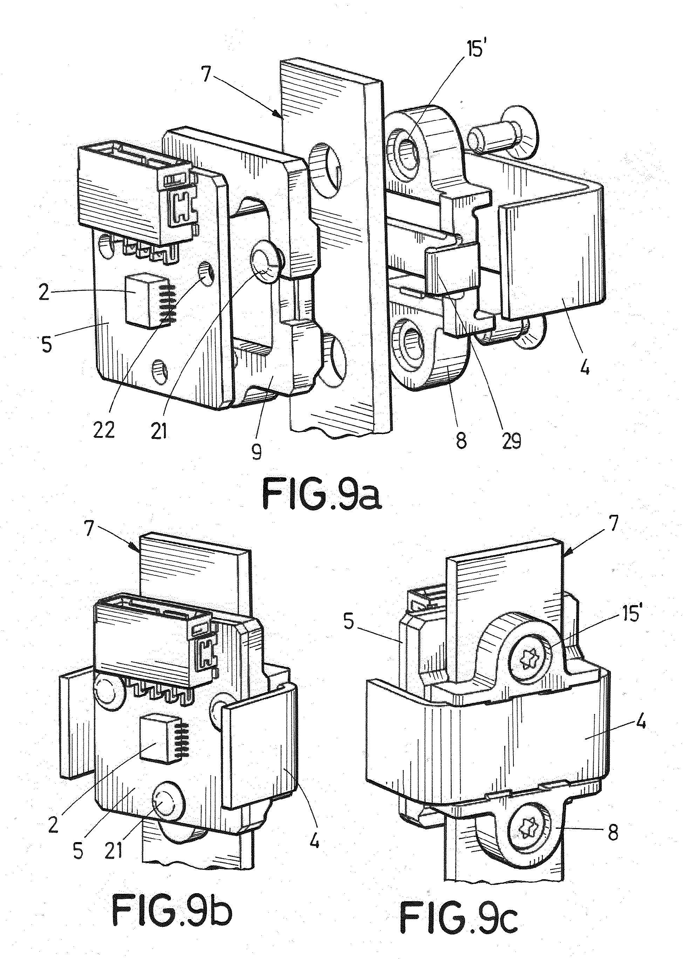

Preferably, as shown in Figures 6-9 and 11, the first non-conductive element 8 has an outer side 8a adapted to engage the flux concentrator 4 and an inner side 8b adapted to be disposed on the first or second side 7a, 7b of the conductor 7.

In the example shown in Figure 6, in particular, in Figures 6b and 6c, the board 5 is disposed on the first side 7a of the conductor 7, and the first non-conductive element 8 is disposed on the second side 7b.

Also, as shown in Figure 6, the first non-conductive element 8 has at least one melting stud 12 that mates with the at least one groove 13 provided at the board 5 to fix them both at respective sides 7a, 7b of the conductor 7. The fixing can be by clipping or ultrasonics.

Further, as shown in Figure 6c, the first non-conductive element 8 can also have fins 11 configured to retain the flux concentrator 4.

According to another preferred embodiment, the current measuring device 1 further comprises a second non-conductive element 9 configured to engage the first non-conductive element 8 to fix them both at respective sides 7a, 7b of the conductor 7.

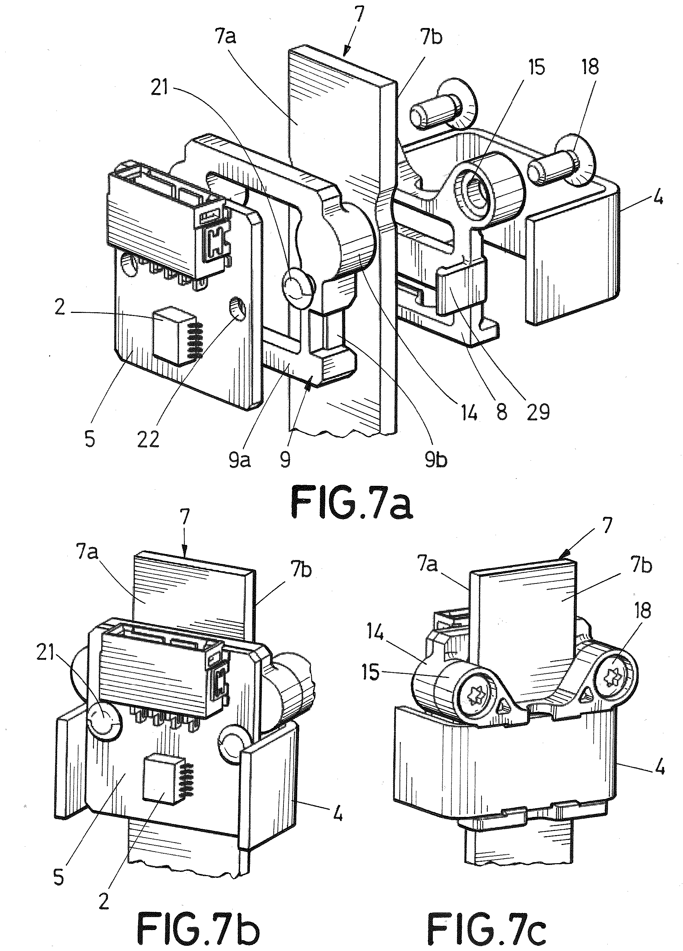

Figures 7-11 shows different examples in which the current measuring device 1 comprises this second non-conductive element 9.

As preferably shown in Figures 7-11, the non-conductive element 9 has an outer side 9a adapted to engage the board 5, and an inner side 9b adapted to be disposed on the opposite side of the conductor 7 on which the first non-conductive element 8 is placed.

Figures 7-9 show different examples not forming part of the invention of current measuring devices 1, that comprises a first magnetic sensor 2, a printed-circuit board 5 on which the first magnetic sensor 2 is disposed, a first non-conductive element 8, a second non-conductive element 9, and the flux concentrator 4.

As shown in Figure 7, the second non-conductive element 9 has at least a second lateral projection 14 that mates with at least a first lateral projection 15 provided at the first non-conductive element 8 to fix them at the both sides 7a, 7b of the conductor 7. The first lateral projection 15 of the first non-conductive element 8 is configured to receive fixing means 18, such as screws or pins, to fix it to the second non-conductive element 9.

As shown in Figures 7-11, the outer side 9a of the second non-conductive element 9 has at least one melting stud 21, and the board 5 has at least one groove 22, said stud 21 and groove 22 being joined by ultrasonic or clipping engagement. This way, the board 5 is securely fixed to the second non-conductive element 9, which, as mentioned, is fixed to the conductor 7 via the first non-conductive element 8.

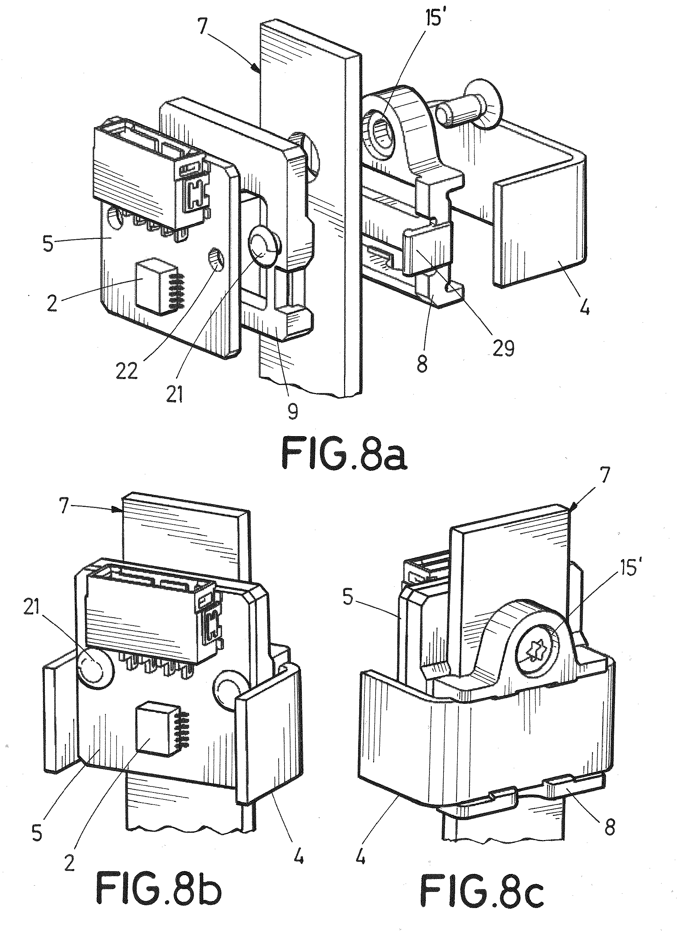

As shown in Figures 8-10, the first non-conductive element 8 has at least a first centred projection 15' to fix it to a second centred projection 14' of the second non-conductive element 9. The first centred projection 15' of the first non-conductive element 8 is configured to receive fixing means 18, such as screws or pins, to fix it to the second centred projection 14' of the second non-conductive part 9, passing through the conductor 7. As shown in Figures 8-10, the conductor 7 can be provided with corresponding holes for the pass of the fixing means 18.

Further, as shown in Figures 7-9, the first non-conductive element 8 can comprise lateral fins 29 to engage the second non-conductive element 9.

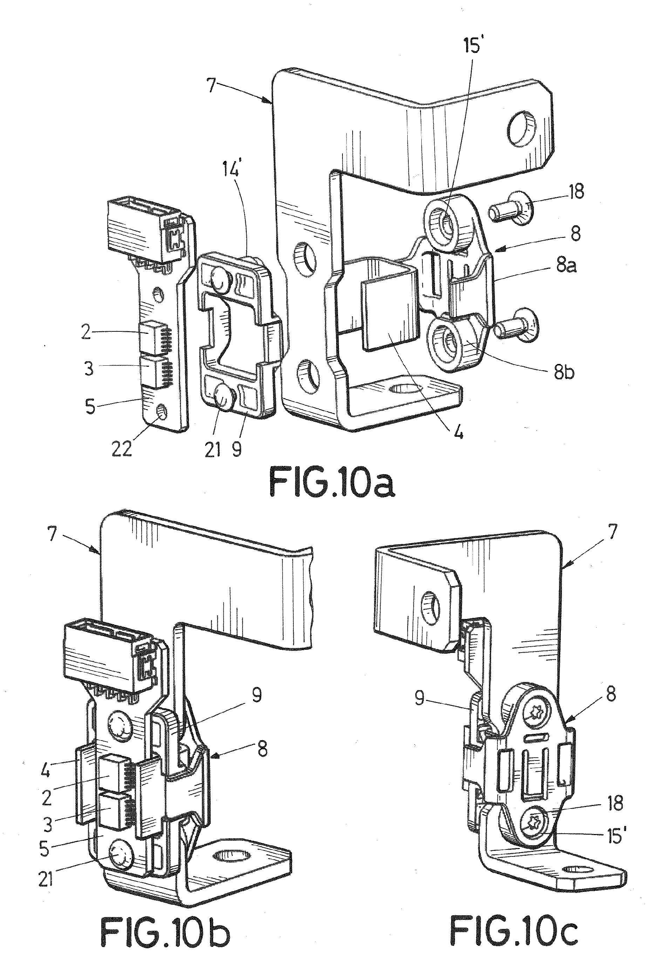

Figures 10-13 show different embodiments of current measuring devices 1 comprising a pair of magnetic sensors 2, 3.

Figures 10-11 show current measuring devices 1 comprising first and second magnetic sensors 2, 3, a printed-circuit board 5 on which the first and second magnetic sensors 2, 3 are disposed, a first non-conductive element 8, a second non-conductive element 9, and a flux concentrator 4.

As shown in Figure 10, the first non-conductive element 8 may have an outer side 8a adapted to receive fixing means 18 to fix it to the second non-conductive element 9, and an inner side 8b adapted to engage the flux concentrator 4.

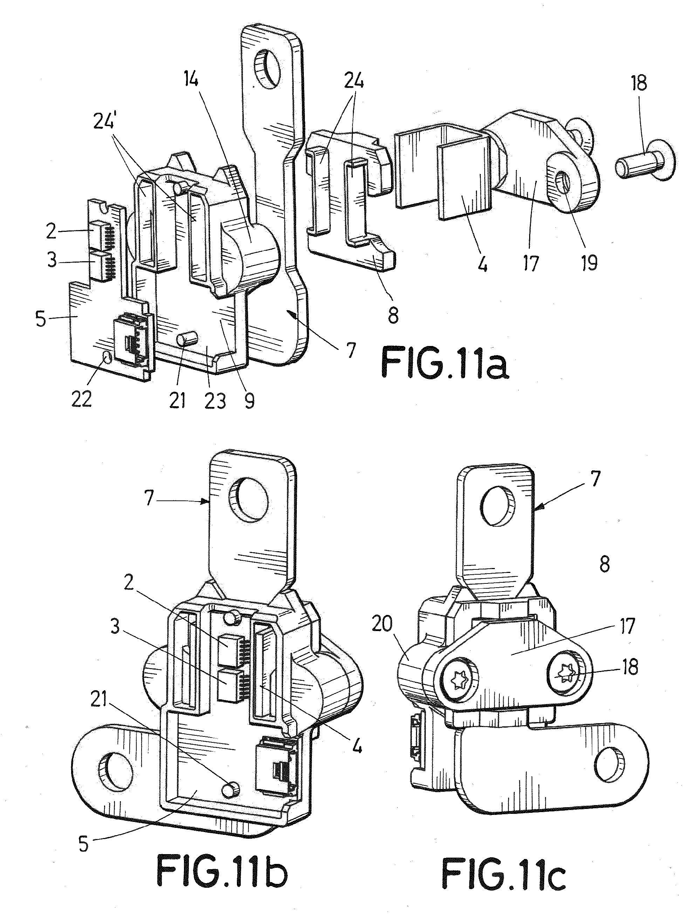

As shown in Figure 11, the current measuring device 1 may further comprise at least one clamp 17 having at least one groove 19, and being configured to retain the flux concentrator 4. The flux concentrator 4 is adapted to fit the first non-conductive element 8. The groove 19 is adapted to receive fixing means 18, such as screws or pins, to fix the clamp 17 to the second non-conductive element 9. For that, the second non-conductive element 9 preferably has at least one lateral projection 14 that mates with the groove 19 of the clamp 17, to fix them at the both sides 7a, 7b of the conductor 7.

According to another preferred embodiment, as shown in Figure 11, the outer side 9a of the second non-conductive element 9 may have a recess 23 configured to receive the board 5.

Further, according to another preferred embodiment, the first 8 and/or second non-conductive element 9 may have a pair of elongate cavities 24, 24' configured to receive the side portions 4a, 4c of the flux concentrator 4.

Figure 11 shows the second non-conductive element 9 having said pair of elongate cavities 24 for receiving the side portions 4a, 4c of the flux concentrator 4.

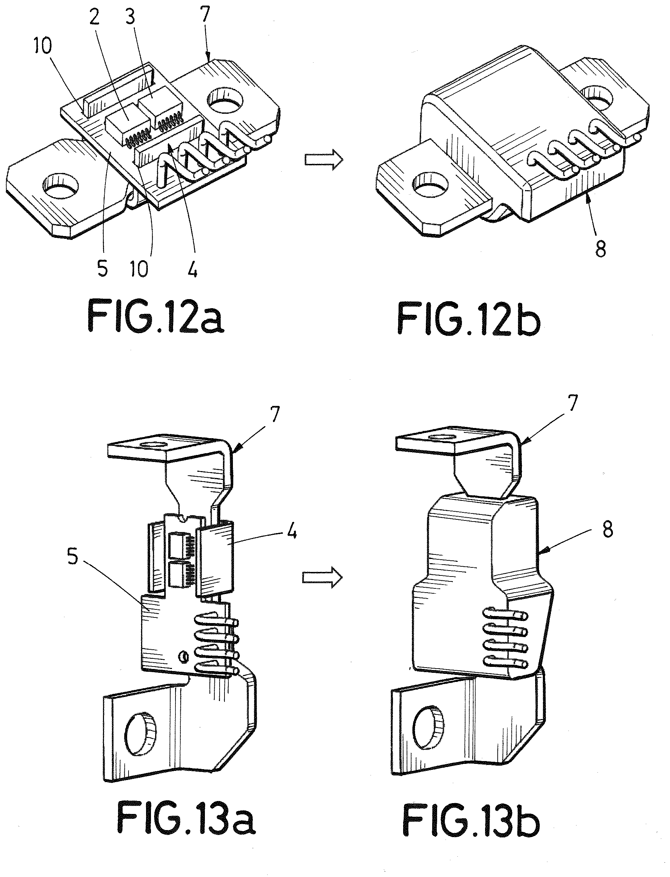

Figures 12-13 show current measuring devices 1 comprising first and second magnetic sensors 2, 3, a printed-circuit board 5 on which the first and second magnetic sensors 2, 3 are disposed, a first non-conductive element 8, and a flux concentrator 4.

As shown in Figures 12-13 and according to another preferred embodiment, the first non-conductive element 8 consists on an overmoulded plastic material to respectively fix the board 5 and the flux concentrator 4 to the first and second sides 7a, 7b of the conductor 7.

Finally, according to another preferred embodiment shown in Figures 10, 11 and 13, the board 5 may have a T-shaped configuration formed by a top portion and a narrower stem portion extending from the top, wherein the first and second magnetic sensors 2, 3 are disposed on the narrower stem portion.

Alternatively, according to another preferred embodiment shown in Figure 12, the board 5 may have two openings 10 configured to receive the side portions 4a, 4c of the flux concentrator 4.

## Claims

1. A current measuring device (1) for a conductor (7) having first (7a) and second sides (7b), comprising:
- a first magnetic sensor (2) to sense a magnetic field generated by a current flowing through the conductor (7),
- a printed-circuit board (5), and
- a first non-conductive element (8),
- wherein the first magnetic sensor (2) is disposed on the printed-circuit board (5), along to a same or a substantially parallel direction in which a current would flow through the conductor (7),
- and wherein the first non-conductive element (8) is configured to be disposed on the first (7a) and/or on the second side (7b) of the conductor (7) to fix the board (5) at one side (7a, 7b) of the conductor (7),
**characterized in that** the current measuring device (1) for a conductor (7) comprises a second magnetic sensor (3), wherein the first and second magnetic sensors (2, 3) are consecutively disposed on the board (5) along to a same or a substantially parallel direction in which a current would flow through the conductor (7), and
**in that** the first magnetic sensor (2) is adapted to operate at a first current range, and the second magnetic sensor (3) is adapted to operate at a second current range, and wherein the first or second current range is respectively contained into the second or the first current range.

2. A current measuring device (1) for a conductor (7), according to any of the preceding claims, further comprising a U-shaped flux concentrator (4) having a central portion (4b) coupled to respective side portions (4a, 4c), wherein the flux concentrator (4) is received by the board (5), such that the at least one of the first and/or second magnetic sensors (2, 3) is disposed between the side portions (4a, 4c) of said flux concentrator (4) to converge a flux generated by a current flowing through the conductor (7) towards at least on of said first and/or second magnetic sensors (2, 3).

3. A current measuring device (1) for a conductor (7), according to any of the preceding claims, further comprising a second non-conductive element (9) configured to engage the first non-conductive element (8) to fix them both at respective sides (7a, 7b) of the conductor (7).

4. A current measuring device (1) for a conductor (7), according to claim 3, wherein the board (5) is received by a side of the first or second non-conductive element (8, 9).

5. A current measuring device (1) for a conductor (7), according to claims 3 and 4, wherein the first or the second non-conductive element (8, 9) are configured to fix the device (1) to the conductor (7).

6. A current measuring device (1) for a conductor (7), according to claims 3 to 5, wherein the first or the second non-conductive element (8) has a side adapted to receive the flux concentrator (4).

7. A current measuring device (1) for a conductor (7), according to any of claims 3 to 6, wherein the first non-conductive element (8) has a first lateral projection (15) that mates with a second lateral projection (14) provided at the second non-conductive element (9) to fix said first and second non-conductive elements (8, 9) at the both sides (7a, 7b) of the conductor (7).

8. A current measuring device (1) for a conductor (7), according to any of claims 3 to 6, wherein at least one of the first or second non-conductive element (8, 9) has a first or second lateral projection (15, 14) to fix said first or second non-conductive element (8, 9) to one side (7a, 7b) of the conductor (7).

9. A current measuring device (1) for a conductor (7), according to any of claims 3-8, wherein the first and/or the second non-conductive elements (8, 9) has at least one melting stud (12, 21) that mates with the at least one groove (13, 22) provided at the board (5).

10. A current measuring device (1) for a conductor (7), according to any of claims 3 to 9, further comprising at least one clamp (17) with at least one groove (19) to fix the first and second non-conductive elements (8, 9) at respective sides (7a, 7b) of the conductor (7).

11. A current measuring device (1) for a conductor (7), according to claim 1, wherein the first non-conductive element (8) consists on an overmoulded plastic material.

12. A current measuring device (1) for a conductor (7), according to claims 2 and 11, wherein the first non-conductive element (8) fixes the board (5) and the flux concentrator (4) at respective sides (7a, 7b) of the conductor (7).

13. A current measuring device (1) for a conductor (7), according to claim 1, wherein the first magnetic sensor (2) is a long-range magnetic sensor, operating at a bigger current range, and the second magnetic sensor (3) is a short-range magnetic sensor, operating at a lower current range.

14. A current measuring device (1) for a conductor (7), according to claim 1, wherein the first magnetic sensor (2) is adapted to operate at VHF (Very High Field), and the second magnetic sensor (3) is adapted to operate at LF (Low Field).

15. A current measuring device (1) for a conductor (7), according to claim 1, wherein the first magnetic sensor (2) is configured to operate having a sensing range of ±52mT at ±500A, and the second magnetic sensor (3) is configured to operate having a sensing range of ±5mT at ±50A.

## Patentansprüche

1. Strommessvorrichtung (1) für einen Leiter (7) mit einer ersten (7a) und einer zweiten Seite (7b), umfassend:
- einen ersten magnetischen Sensor (2) zum Erfassen eines magnetischen Feldes, das von einem durch den Leiter (7) fließenden Strom erzeugt wird,
- eine Leiterplatte (5), und
- ein erstes nichtleitendes Element (8),
- wobei der erste magnetische Sensor (2) auf der Leiterplatte (5) entlang einer Richtung gleich oder im Wesentlichen parallel zu einer Richtung, in der ein Strom durch den Leiter (7) fließen würde, angeordnet ist,
- und wobei das erste nichtleitende Element (8) dafür konfiguriert ist, auf der ersten (7a) und/oder auf der zweiten Seite (7b) des Leiters (7) angeordnet zu sein, um die Leiterplatte (5) an einer Seite (7a, 7b) des Leiters (7) zu befestigen,
**dadurch gekennzeichnet, dass** die Strommessvorrichtung (1) für einen Leiter (7) einen zweiten magnetischen Sensor (3) umfasst, wobei der erste und der zweite magnetische Sensor (2, 3) nacheinander auf der Platine (5) entlang einer Richtung gleich oder im Wesentlichen parallel zu einer Richtung, in der ein Strom durch den Leiter (7) fließen würde, angeordnet sind, und
dass der erste magnetische Sensor (2) dafür ausgelegt ist, in einem ersten Strombereich zu arbeiten, und der zweite Magnetsensor (3) dafür ausgelegt ist, in einem zweiten Strombereich zu arbeiten, und wobei der erste oder der zweite Strombereich jeweils in dem zweiten oder dem ersten Strombereich enthalten ist.

2. Strommessvorrichtung (1) für einen Leiter (7) nach einem der vorangehenden Ansprüche, ferner einen U-förmigen Flusskonzentrator (4) umfassend, der einen zentralen Abschnitt (4b) aufweist, der mit jeweiligen Seitenabschnitten (4a, 4c) gekoppelt ist, wobei der Flusskonzentrator (4) von der Platine (5) so aufgenommen ist, dass der wenigstens eine des ersten und/oder des zweiten magnetischen Sensors (2, 3) zwischen den Seitenabschnitten (4a, 4c) des Flusskonzentrators (4) angeordnet ist, um einen Fluss, der von einem durch den Leiter (7) fließenden Strom erzeugt wird, in Richtung zu wenigstens einem des ersten und/oder des zweiten magnetischen Sensors (2, 3) zu bündeln.

3. Strommessvorrichtung (1) für einen Leiter (7) nach einem der vorangehenden Ansprüche, ferner ein zweites nichtleitendes Element (9) umfassend, das dafür konfiguriert ist, mit dem ersten nichtleitenden Element (8) in Eingriff zu gelangen, um beide an entsprechenden Seiten (7a, 7b) des Leiters (7) zu befestigen.

4. Strommessvorrichtung (1) für einen Leiter (7) nach Anspruch 3, wobei die Leiterplatte (5) von einer Seite des ersten oder des zweiten nichtleitenden Elements (8, 9) aufgenommen ist.

5. Strommessvorrichtung (1) für einen Leiter (7) nach einem der Ansprüche 3 und 4, wobei das erste oder das zweite nichtleitende Element (8, 9) dafür konfiguriert ist, die Vorrichtung (1) mit dem Leiter (7) zu verbinden.

6. Strommessvorrichtung (1) für einen Leiter (7) nach einem der Ansprüche 3 bis 5, wobei das erste oder das zweite nichtleitende Element (8) eine Seite aufweist, die dafür ausgelegt ist, den Flusskonzentrator (4) aufzunehmen.

7. Strommessvorrichtung (1) für einen Leiter (7) nach einem der Ansprüche 3 bis 6, wobei das erste nichtleitende Element (8) einen ersten lateralen Vorsprung (15) aufweist, der mit einem zweiten lateralen Vorsprung (14), der an dem zweiten nichtleitenden Element (9) vorgesehen ist, zusammenpasst, um das erste bzw. das zweite nichtleitende Element (8, 9) an den beiden Seiten (7a, 7b) des Leiters (7) zu befestigen.

8. Strommessvorrichtung (1) für einen Leiter (7) nach einem der Ansprüche 3 bis 6, wobei wenigstens eines des ersten oder des zweiten nichtleitenden Elements (8, 9) einen ersten oder einen zweiten lateralen Vorsprung (15, 14) aufweist, um das erste oder das zweite nichtleitende Element (8, 9) an einer Seite (7a, 7b) des Leiters (7) zu befestigen.

9. Strommessvorrichtung (1) für einen Leiter (7) nach einem der Ansprüche 3 bis 8, wobei das erste und/oder das zweite nichtleitende Element (8, 9) wenigstens einen Schmelzstift (12, 21) aufweist, der mit wenigstens einer an der Platine (5) vorgesehenen Nut (13, 22) zusammenpasst.

10. Strommessvorrichtung (1) für einen Leiter (7) nach einem der Ansprüche 3 bis 9, ferner wenigstens eine Klemme (17) mit wenigstens einer Nut (19) umfassend, um das erste und das zweite nichtleitende Element (8, 9) an den jeweiligen Seiten (7a, 7b) des Leiters (7) zu befestigen.

11. Strommessvorrichtung (1) für einen Leiter (7) nach Anspruch 1, wobei das erste nichtleitende Element (8) aus einem umspritzten Kunststoffmaterial besteht.

12. Strommessvorrichtung (1) für einen Leiter (7) nach einem der Ansprüche 2 und 11, wobei das erste nichtleitende Element (8) die Leiterplatte (5) und den Flusskonzentrator (4) an den jeweiligen Seiten (7a, 7b) des Leiters (7) befestigt.

13. Strommessvorrichtung (1) für einen Leiter (7) nach Anspruch 1, wobei der erste magnetische Sensor (2) ein magnetischer Fernbereichssensor ist, der in einem höheren Strombereich arbeitet, und der zweite magnetische Sensor (3) ein magnetischer Nahbereichssensor ist, der in einem niedrigeren Strombereich arbeitet.

14. Strommessvorrichtung (1) für einen Leiter (7) nach Anspruch 1, wobei der erste magnetische Sensor (2) dafür ausgelegt ist, bei sehr starkem Feld (VHF, very high field) zu arbeiten und der zweite magnetische Sensor (3) dafür ausgelegt ist, bei schwachem Feld (LF, low field) zu arbeiten.

15. Strommessvorrichtung (1) für einen Leiter (7) nach Anspruch 1, wobei der erste magnetische Sensor (2) dafür konfiguriert ist, mit einem Erfassungsbereich von ±52mT bei ±500A zu arbeiten, und der zweite magnetische Sensor (3) dafür konfiguriert ist, mit einem Erfassungsbereich von ±5mT bei ±50A zu arbeiten.

## Revendications

1. Dispositif de mesure de courant (1) pour un conducteur (7) ayant des premier (7a) et second (7b) côtés, comprenant :
- un premier capteur magnétique (2) pour détecter un champ magnétique généré par un courant circulant à travers le conducteur (7),
- une carte de circuit imprimé (5), et
- un premier élément non-conducteur (8),
- dans lequel le premier capteur magnétique (2) est disposé sur la carte de circuit imprimé (5), le long d'une même direction ou d'une direction sensiblement parallèle dans laquelle un courant circulerait à travers le conducteur (7),
- et dans lequel le premier élément non-conducteur (8) est configuré pour être disposé sur le premier (7a) et/ou sur le second côté (7b) du conducteur (7) pour fixer la carte (5) sur un côté (7a, 7b) du conducteur (7),
**caractérisé en ce que** le dispositif de mesure de courant (1) pour un conducteur (7) comprend un second capteur magnétique (3), dans lequel les premier et second capteurs magnétiques (2, 3) sont disposés consécutivement sur la carte (5) le long d'une même direction ou d'une direction sensiblement parallèle dans laquelle un courant circulerait à travers le conducteur (7), et
**en ce que** le premier capteur magnétique (2) est adapté pour fonctionner à une première plage de courant, et le second capteur magnétique (3) est adapté pour fonctionner à une seconde plage de courant, et dans lequel la première ou la seconde plage de courant est respectivement contenue dans la seconde ou la première plage de courant.

2. Dispositif de mesure de courant (1) pour un conducteur (7), selon l'une quelconque des revendications précédentes, comprenant en outre un concentrateur de flux en forme de U (4) ayant une partie centrale (4b) couplée à des parties de côté respectives (4a, 4c), dans lequel le concentrateur de flux (4) est reçu par la carte (5), de sorte que ledit au moins un des premier et/ou second capteurs magnétiques (2, 3) est disposé entre les parties de côté (4a, 4c) dudit concentrateur de flux (4) pour faire converger un flux généré par un courant circulant à travers le conducteur (7) vers au moins un desdits premier et/ou second capteurs magnétiques (2, 3).

3. Dispositif de mesure de courant (1) pour un conducteur (7), selon l'une quelconque des revendications précédentes, comprenant en outre un second élément non-conducteur (9) configuré pour s'engager avec le premier élément non-conducteur (8) pour les fixer tous les deux sur des côtés respectifs (7a, 7b) du conducteur (7).

4. Dispositif de mesure de courant (1) pour un conducteur (7), selon la revendication 3, dans lequel la carte (5) est reçue par un côté du premier ou du second élément non-conducteur (8, 9).

5. Dispositif de mesure de courant (1) pour un conducteur (7), selon les revendications 3 et 4, dans lequel le premier ou le second élément non-conducteur (8, 9) sont configurés pour fixer le dispositif (1) au conducteur (7).

6. Dispositif de mesure de courant (1) pour un conducteur (7), selon les revendications 3 à 5, dans lequel le premier ou le second élément non-conducteur (8) a un côté adapté pour recevoir le concentrateur de flux (4).

7. Dispositif de mesure de courant (1) pour un conducteur (7), selon l'une quelconque des revendications 3 à 6, dans lequel le premier élément non-conducteur (8) a une première saillie latérale (15) qui s'adapte à une seconde saillie latérale (14) prévue au niveau du second élément non-conducteur (9) pour fixer lesdits premier et second éléments non-conducteurs (8, 9) au niveau des deux côtés (7a, 7b) du conducteur.

8. Dispositif de mesure de courant (1) pour un conducteur (7), selon l'une quelconque des revendications 3 à 6, dans lequel au moins un élément parmi le premier ou le second élément non-conducteur (8, 9) a une première ou une seconde saillie latérale (15, 14) pour fixer ledit premier ou second élément non-conducteur (8, 9) sur un côté (7a, 7b) du conducteur (7).

9. Dispositif de mesure de courant (1) pour un conducteur (7), selon l'une quelconque des revendications 3 à 8, dans lequel le premier et/ou le second élément non-conducteur (8, 9) a au moins un goujon de fusion (12, 21) qui s'adapte à ladite au moins une rainure (13, 22) prévue sur la carte (5).

10. Dispositif de mesure de courant (1) pour un conducteur (7), selon l'une quelconque des revendications 3 à 9, comprenant en outre au moins un élément de serrage (17) avec au moins une rainure (19) pour fixer les premier et second éléments non-conducteurs (8, 9) sur les côtés respectifs (7a, 7b) du conducteur (7).

11. Dispositif de mesure de courant (1) pour un conducteur (7), selon la revendication 1, dans lequel le premier élément non-conducteur (8) consiste en une matière plastique surmoulée.

12. Dispositif de mesure de courant (1) pour un conducteur (7), selon les revendications 2 et 11, dans lequel le premier élément non-conducteur (8) fixe la carte (5) et le concentrateur de flux (4) sur les côtés respectifs (7a, 7b) du conducteur (7).

13. Dispositif de mesure de courant (1) pour un conducteur (7), selon la revendication 1, dans lequel le premier capteur magnétique (2) est un capteur magnétique à longue portée, fonctionnant à une plage de courant plus grande, et le second capteur magnétique (3) est un capteur magnétique à faible portée, fonctionnant à une plage de courant inférieure.

14. Dispositif de mesure de courant (1) pour un conducteur (7), selon la revendication 1, dans lequel le premier capteur magnétique (2) est adapté pour fonctionner en champ intense (Very High Field), et le second capteur magnétique (3) est adapté pour fonctionner à faible champ (Low Field).

15. Dispositif de mesure de courant (1) pour un conducteur (7), selon la revendication 1, dans lequel le premier capteur magnétique (2) est configuré pour fonctionner avec une plage de détection de ±52mT à ±500A, et
le second capteur magnétique (3) est configuré pour fonctionner avec une plage de détection de ±5mT à ±50A.
